# FASCICULE DE BREVET EUROPEEN

(11) **EP 2 556 533 B1**
(45) Date de publication et mention de la délivrance du brevet: **07.10.2020**
(21) Numéro de dépôt: 11718462.2
(22) Date de dépôt: 07.04.2011
(51) Int. Cl.: H01L 21/8242, H01L 21/84, H01L 29/78, G11C 11/404, H01L 27/108

(54) **POINT MEMOIRE RAM A UN TRANSISTOR**
RAM-SPEICHERZELLE MIT EINEM TRANSISTOR
RAM MEMORY CELL COMPRISING A TRANSISTOR

(30) Priorité: 07.04.2010 FR 1052612
(43) Date de publication de la demande: 13.02.2013
(73) Titulaire: Centre National de la Recherche Scientifique, 75794 Paris Cedex 16 (FR); Universidad De Granada, 18100 Armilla (Granada) (ES)
(72) Inventeur: CRISTOLOVEANU, Sorin, Ioan, F-38170 Seyssinet (FR); RODRIGUEZ, Noel, E-18.100 Armilla (granada) (ES); GAMIZ, Francisco, E-18.100 Armilla (granada) (ES)
(74) Mandataire: Lavoix
(86) Numéro de dépôt international: PCT/FR2011/050788
(87) Numéro de publication internationale: WO 2011/124855

(56) Documents cités:
- WO-A1-88/08617
- WO-A1-2010/119224
- US-A1- 2008 303 063
- US-A1- 2009 194 824
- NOEL RODRIGUEZ ET AL: "A-RAM: Novel capacitor-less DRAM memory", SOI CONFERENCE, 2009 IEEE INTERNATIONAL, IEEE, PISCATAWAY, NJ, USA, 5 octobre 2009 (2009-10-05), pages 1-2, XP031561473, ISBN: 978-1-4244-4256-0
- TANAKA T ET AL: "Scalability study on a capacitorless 1T-DRAM from single-gate PD-SOI to double-gate FinDRAM", ELECTRON DEVICES MEETING, 2004. IEDM TECHNICAL DIGEST. IEEE INTERNATIO NAL SAN FRANCISCO, CA, USA DEC. 13-15, 2004, PISCATAWAY, NJ, USA,IEEE LNKD- DOI:10.1109/IEDM.2004.1419332, 13 décembre 2004 (2004-12-13), pages 919-922, XP010788953, ISBN: 978-0-7803-8684-6

## Description

### Domaine de l'invention

La présente invention concerne un point mémoire RAM à un transistor.

### Exposé de l'art antérieur

Historiquement, les points mémoire DRAM ont été constitués d'un ensemble comprenant un transistor MOS et un condensateur. Avec la miniaturisation des circuits intégrés, les transistors MOS ont pu avoir des dimensions de plus en plus petites et la difficulté a consisté à réduire la taille des condensateurs. Pour pallier cette difficulté, on a proposé des points mémoire constitués d'un unique transistor, sans condensateur, le transistor MOS étant à corps isolé par jonction, ou à corps isolé par isolant dans des technologies de type semiconducteur sur isolant (SOI ou Semiconductor On Insulator) ou semiconducteur sur rien (SON ou Semiconductor On Nothing). Dans ces points mémoire, la mémorisation correspond à un stockage de charges dans le transistor. Ceci a conduit à une miniaturisation accrue des cellules DRAM. Toutefois, les divers points mémoire sans condensateur connus souffrent généralement d'au moins l'un des inconvénients suivants : durée de rétention limitée, consommation élevée, faible différenciation entre les deux états de mémorisation, complexité de commande, utilisation de deux grilles, faible vitesse de fonctionnement, impossibilité de réduire l'épaisseur du corps du transistor qui doit assurer la présence simultanée d'électrons et de trous, et/ou difficulté de fabrication.

WO 2010/119224 A1 décrit un point mémoire constitué d'un transistor MOS ayant un drain, une source et une région de corps revêtue d'une grille isolée, dans lequel la région de corps est divisée dans son épaisseur en deux régions distinctes séparées par une portion de couche isolante s 'étendant parallèlement au plan de la grille.

NOEL RODRIGUEZ ET AL: "A-RAM: Novel capacitor-less DRAM memory", SOI CONFERENCE, 2009 IEEE INTERNATIONAL, IEEE, PISCATANAY, NJ, USA, décrit une cellule mémoire à un seul transistor comprenant un corps partitionné en deux régions, où des électrons et des trous sont respectivement confinés.

US 2009/194824 A1 décrit un transistor comportant une région de drain et une région de source ayany une première conductivité et une région de corps formée entre le drain et la source et d'une deuxième conductivité différente de la première conductivité.

### Résumé

Ainsi, un objet de l'invention est de prévoir un point mémoire RAM à un seul transistor, sans condensateur, qui pallie au moins certains des inconvénients des points mémoire à transistor unique connus.

Ainsi, un mode de réalisation de la présente invention prévoit un point mémoire selon la revendication 1.

Certains modes de réalisation de la présente invention sont décrits dans les revendications dépendantes.

Un mode de réalisation de la présente invention prévoit un procédé d'utilisation d'un point mémoire selon la revendication 6.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
la figure 1 est une vue en coupe schématique d'un point mémoire selon un mode de réalisation de la présente invention ;
les figures 2A et 2B illustrent l'écriture d'un 1 dans un point mémoire selon un mode de réalisation de la présente invention ;
la figure 3 illustre l'écriture d'un 0 dans un point mémoire selon un mode de réalisation de la présente invention ;
les figures 4A et 4B illustrent la lecture, respectivement d'un 0 et d'un 1, dans un point mémoire selon un mode de réalisation de la présente invention ;
les figures 5A, 5B, 5C illustrent des tensions appliquées, respectivement pour l'écriture d'un 1, l'écriture d'un 0, et la lecture dans un point mémoire selon un mode de réalisation de la présente invention ;
la figure 6 est une vue schématique en coupe et en perspective d'une variante d'un point mémoire selon un mode de réalisation de la présente invention ; et
la figure 7 est une vue schématique en coupe et en perspective d'une autre variante d'un point mémoire selon un mode de réalisation de la présente invention.

Par souci de clarté, de mêmes éléments ont été désignés par de mêmes références aux différentes figures et, comme cela est habituel dans la représentation des circuits intégrés, les diverses figures ne sont pas tracées à l'échelle.

### Description détaillée

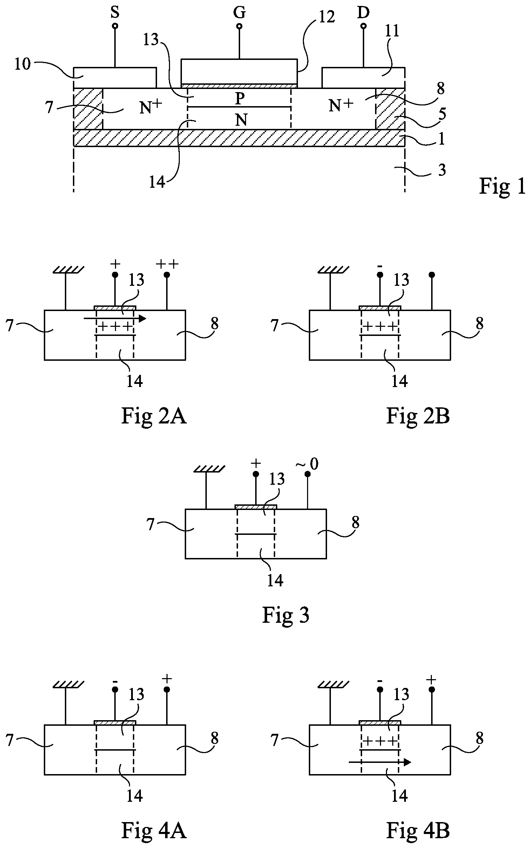

La figure 1 est une vue en coupe illustrant un point mémoire sans condensateur. Ce point mémoire comprend un transistor MOS formé sur une couche isolante 1 reposant sur un support 3, généralement une plaque de silicium. La zone occupée par le transistor MOS, ou zone active, est délimitée par une périphérie isolante 5. Le transistor MOS comprend des régions de source et de drain fortement dopées d'un premier type de conductivité 7 et 8 séparées par une région de corps. Dans ce qui suit, on considérera que le premier type de conductivité est le type N et que le second type de conductivité est le type P, bien que cela ne doive pas être considéré comme limitatif. Les régions de source et de drain sont respectivement solidaires d'une métallisation de source 10 et d'une métallisation de drain 11 reliées à des bornes de source S et de drain D. La partie de corps du transistor est surmontée d'une grille isolée 12 reliée à une borne de grille G. La région de corps est divisée dans le sens de son épaisseur en une région de corps supérieure 13 du côté de la grille 12 et une région de corps inférieure 14 au voisinage de la couche isolante 1. La région de corps supérieure 13 est du type de conductivité opposé à celui des drain/source et a un niveau de dopage inférieur à 10¹⁶ atomes/cm³. La région de corps inférieure 14 est du même type de conductivité que celui des drain/source. Son niveau de dopage est de préférence choisi dans une plage de 10¹⁶ à 10¹⁸ atomes/cm³ en fonction de son épaisseur de façon que cette partie inférieure 14 soit complètement déplétée à l'état 0 et qu'elle contienne suffisamment d'électrons disponibles à l'état 1, les états 0 et 1 étant définis ci-après.

La structure de la figure 1 sera de préférence réalisée en utilisant des technologies permettant d'obtenir des épaisseurs de couche avec une précision meilleure que 5 nm, de préférence de l'ordre du nm. On choisira également des technologies dans lesquelles les dimensions latérales peuvent être définies avec des valeurs minimales inférieures à 50 nm. Dans ces conditions, uniquement à titre d'exemple, on pourra choisir de réaliser une structure dans laquelle l'épaisseur totale du transistor est inférieure à 100 nm, la région de corps supérieure ayant une épaisseur de 5 à 50 nm, de préférence voisine de 10 nm, et la région de corps inférieure ayant une épaisseur de 5 à 50 nm, de préférence de 10 à 40 nm. La longueur de canal du transistor sera de préférence inférieure à 65 nm, par exemple 35 nm.

La façon dont la structure de la figure 1 peut être utilisée en point mémoire va maintenant être décrite en relation avec les figures 2 à 4.

Les figures 2A et 2B illustrent des étapes d'écriture d'un 1 dans le point mémoire de la figure 1. Dans ce qui suit, on supposera que la source S est en permanence connectée à une tension de référence qui est désignée par souci de simplicité comme étant la masse.

Pour écrire un 1, on applique d'abord comme l'illustre la figure 2A une tension positive relativement élevée, par exemple 1 à 3 volts, sur le drain du transistor, et la grille est mise à un potentiel positif pendant une courte durée, pendant que la tension positive est appliquée sur le drain. Il en résulte qu'une région de canal est formée dans la région de corps supérieure (pendant cette phase, une faible proportion de courant peut sans inconvénient circuler dans la région de corps inférieure) et que des électrons circulent de la source au drain. Etant donné que la différence de potentiel drain-source est choisie relativement élevée, ces électrons vont créer par impact des paires électrons-trous dans la région de corps supérieure. Les électrons créés participent à la circulation de courant et les trous demeurent dans la région de corps supérieure. Si on interrompt brutalement (figure 2B) le passage de courant entre source et drain, en commutant la grille à un potentiel négatif avant de commuter le drain, des trous désignés par des signes + en figures 2A et 2B, demeureront dans la région de corps supérieure 13.

La figure 3 illustre l'écriture d'un 0 dans le point mémoire. A nouveau, on rend la grille positive mais cette fois-ci, on connecte le drain 8 à une tension faiblement positive, nulle ou même négative. Alors, la différence de potentiel source drain est insuffisante pour assurer la création de paires électrons-trous, et, en raison de la polarisation électrostatique créée par la grille dans la région de corps supérieure 13, les trous éventuellement présents dans cette région de corps supérieure seront évacués vers le drain et/ou la source. Ainsi, les états de la figure 2B et de la figure 3 se différencient par le fait que dans un cas (écriture d'un 1) des trous sont stockés dans la région de corps supérieure 13 et que dans l'autre cas (écriture d'un 0), aucune charge n'est stockée dans cette région de corps supérieure.

Les figures 4A et 4B illustrent respectivement la lecture d'un 0 et la lecture d'un 1 dans le point mémoire de la figure 1. En phase de lecture (ou de rétention), on maintient une tension négative sur la grille et une tension faiblement positive sur le drain.

Comme l'illustre la figure 4A, dans le cas où un 0 a été mémorisé, c'est-à-dire qu'aucune charge n'est stockée dans la région de corps supérieure 13, les transistors en parallèle partageant un même drain et une même source sont tous deux bloqués : il ne passe pas de courant dans le transistor correspondant à la région de corps supérieure puisque la grille est négative, et la tension négative de grille déplète la région de corps inférieure qui ne laisse donc également pas passer de courant. On comprendra que la région de corps supérieure doit être suffisamment mince pour que la grille ait une influence suffisante sur la région de corps inférieure, c'est pourquoi on a indiqué que cette région de corps supérieure avait une épaisseur de préférence voisine de 10 nm.

Par contre, comme l'illustre la figure 4B, dans le cas où un 1 a été écrit, c'est-à-dire que des charges positives sont stockées dans la région de corps supérieure 13, aucun courant ne circule dans le transistor correspondant à cette région de corps supérieure puisque la grille est négative et qu'il n'est pas créé de région de canal d'électrons dans cette région de corps supérieure. Par contre, les charges positives stockées dans la région de corps supérieure font écran au potentiel négatif de la grille et un courant d'électrons va circuler dans le transistor ayant pour source et drain les régions 7 et 8 et comme corps la région non déplétée de corps inférieure 14.

Ainsi, on pourra reconnaître un état 1 d'un état 0 par la circulation d'un courant ou l'absence de circulation d'un courant lors d'une phase de lecture. On remarquera que ces deux états sont très bien différenciés car, pendant la lecture d'un 0, il ne circule absolument aucun courant entre drain et source. L'absence totale de circulation de courant pendant un état 0, fait que le dispositif présente un temps de rétention très long puisque, même si pendant la lecture d'un état 1 il se produit une légère perte des charges stockées dans la région de corps supérieure, il existera toujours une nette différenciation entre les états 0 et 1.

On notera également que, du fait que pendant l'état de lecture seul un potentiel faiblement positif est appliqué sur le drain, il ne se crée pas de charges par impact dans la région de corps inférieure 14 pendant une lecture.

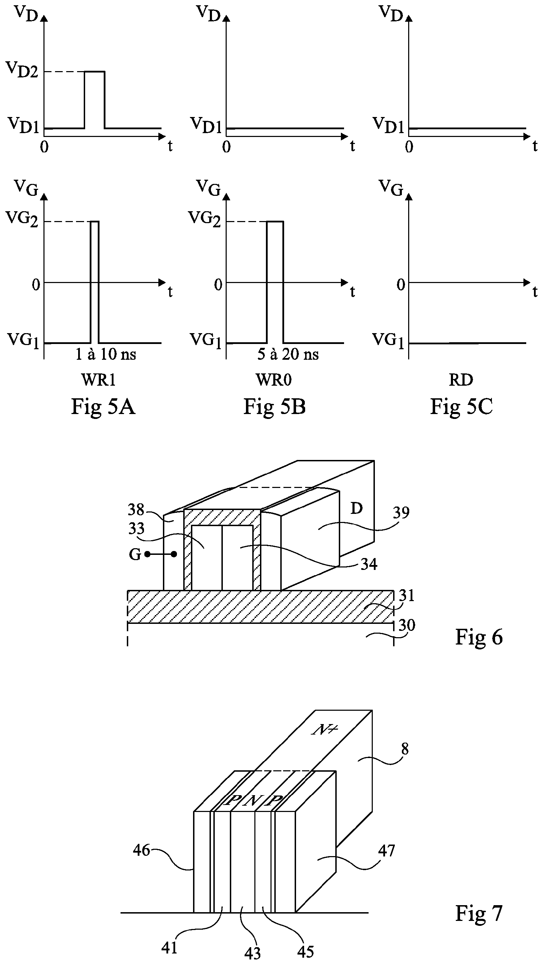

Pour mieux illustrer le fonctionnement du point mémoire, chacune des figures 5A, 5B et 5C représente l'allure des tensions de drain (VD) et de grille (VG), respectivement pendant les états d'écriture d'un 1 (WR1), d'écriture d'un 0 (WR0) et de lecture (RD). Pendant l'écriture d'un 1 (figure 5A), la tension de drain est amenée à passer d'une tension nulle ou faiblement positive VD1, par exemple 0,1 V, à une tension VD2 nettement positive, par exemple 1 à 2,2 V et, pendant la période (par exemple 5 à 30 ns) durant laquelle la tension de drain VD2 est appliquée, la grille est brièvement (par exemple pendant 1 à 10 ns) amenée d'une valeur négative VG1 à une valeur positive VG2, par exemple de -1,2 volt à + 1 volt. Pour l'écriture d'un zéro (figure 5B), la tension de drain est maintenue à la valeur basse VD1 et la grille est amenée pendant une courte période, par exemple de l'ordre de 1 à 10 nanosecondes à une valeur positive pour permettre l'évacuation de charges éventuellement présentes dans la région de corps supérieure. Dans l'état de lecture, ou de rétention (figure 5C), le drain est maintenu à la valeur faible de tension VD1 et la grille est maintenue à sa valeur négative VG1.

Le mode d'application de tensions décrit en relation avec les figures 5A à 5C est particulièrement avantageux car il ne prévoit que deux niveaux de tension possibles sur la grille et sur le drain. On pourra toutefois prévoir des modes de commutation de tension plus complexes, dans lesquels par exemple, la tension de drain serait commutable entre plus de deux niveaux de tension, par exemple un troisième niveau de tension nul ou négatif pendant la phase d'écriture d'un 0, ou un niveau de tension nul pendant la phase de rétention. Pendant les phases d'écriture d'un 1, au lieu de créer des trous par ionisation par impact, on pourra utiliser d'autres phénomènes. En appliquant une tension fortement négative (par exemple -2,5 V) à la grille, et une tension positive au drain, des trous seront créés par effet tunnel bande à bande (B to B tunelling) ou par activation du transistor bipolaire parasite. Actuellement, c'est la création de trous par effet tunnel bande à bande qui constitue le mode de réalisation préféré.

On notera que les valeurs de tension indiquées ci-dessus sont purement indicatives et sont données pour un point mémoire ayant sensiblement les dimensions indiquées précédemment. L'homme de l'art saura adapter ces valeurs aux caractéristiques spécifiques d'un composant particulier.

La réalisation d'une structure telle que celle de la figure 1 est particulièrement simple.

Par exemple, on pourra partir d'une structure de type SOI comprenant, sur un support 3 revêtu d'une couche isolante 1, un substrat dopé de type N sur lequel on fait croître par épitaxie une couche faiblement dopée de type P. Ensuite, ou lors d'une étape intermédiaire, on forme la périphérie isolante 5 entourant la zone active désirée puis on procède aux étapes classiques de formation d'un oxyde de grille, d'une grille et des régions de source-drain.

Le point mémoire décrit ci-dessus est susceptible de nombreuses variantes et modifications.

La figure 6 illustre une réalisation selon une configuration généralement appelée dans la technique structure FINFET (transistor à effet de champ à structure en ailette). Cette figure est une vue en coupe et en perspective de la partie de corps et de la partie de drain de la structure, la partie de source, non représentée, étant en avant du plan de la figure. Une excroissance de silicium en ailette est formée au-dessus d'une plaquette 30 revêtue d'une couche isolante 31. Cette excroissance est divisée en une partie gauche 33 et une partie droite 34 correspondant respectivement à la région de corps supérieure 13 et à la région de corps inférieure 14 de la figure 1. Des métallisations de grilles isolées 38 et 39 sont disposées de part et d'autre de l'ailette, en regard du corps de gauche 33 et du corps de droite 34. Les deux grilles 38 et 39 pourraient être utilisées pour inverser sélectivement les fonctions des parties de corps de gauche et de droite. De même, dans la structure de la figure 1, on pourrait prévoir de polariser sélectivement le support 3 pour agir sur la région de corps inférieure 14 à travers la couche isolante 1, par exemple pour ajuster la tension de seuil du transistor inférieur. On pourra aussi ajouter une grille inférieure.

La figure 7 illustre très schématiquement une réalisation FINFET d'une variante de la structure de la figure 1. Le corps du transistor, au lieu d'être divisé en deux régions, est divisé en trois régions : une région de gauche 41 de type P, une région centrale 43 de type N et une région de droite 45 de type P. Une grille isolée 46 est disposée en regard de la région de gauche 41 et une grille isolée 47 est disposée en regard de la région de droite 45. On obtient ainsi un point mémoire bibit, c'est-à-dire un point mémoire à quatre états. La grille de gauche permet de stocker ou non des charges dans la région de corps de gauche 41. La grille de droite permet de stocker ou non des charges dans la région de corps de droite 45. On obtient un premier état (11) si des charges sont stockées à gauche et à droite, un deuxième état (00) si aucune charge n'est stockée ni à gauche ni à droite, un troisième état (10) si des charges sont stockées à gauche et pas à droite, et un quatrième état (01) si des charges sont stockées dans la région à droite et pas à gauche. Les états (01) et (10) pourront être différenciés de diverses manières. Notamment, si les grilles de gauche et de droite sont différentes (travail de sortie différent ou épaisseur d'isolant différente) et/ou si les tensions appliquées sont différentes, on stockera à chaque écriture d'un 1 une quantité plus ou moins grande de charges dans la région de corps de gauche et dans la région de corps de droite. Ainsi, les quatre valeurs possibles du courant dans la région de corps centrale peuvent être bien différenciées.

Des modes de réalisation particuliers de la présente invention ont été décrits. Diverses variantes et modifications apparaîtront à l'homme de l'art. En particulier, diverses variantes de réalisation de transistors MOS pourront être adoptées, par exemple la réalisation de zones de source et de drain faiblement dopées (LDD) au voisinage de la région de canal.

On comprendra également que le fait que l'on ait appelé état 1 l'un des états de mémorisation et état 0 l'autre des états de mémorisation est parfaitement arbitraire.

Dans ce qui a été décrit précédemment, on utilise un transistor à deux corps : un corps susceptible de stocker des charges d'une première polarité et un corps susceptible de laisser passer des charges de polarité opposée. Il n'y a donc pas de coexistence de charges de polarités opposées dans un même corps. Ceci est l'une des raisons principales pour lesquelles la structure décrite évite les inconvénients susmentionnés des points mémoire à un transistor de l'art antérieur (durée de rétention limitée, consommation élevée, faible différenciation entre les deux états de mémorisation, complexité de commande, faible vitesse de fonctionnement, impossibilité de réduire l'épaisseur du corps du transistor qui doit assurer la présence simultanée d'électrons et de trous). De plus le dispositif décrit peut fonctionner avec une seule grille et est relativement simple à commander.

Divers modes de réalisation et diverses variantes d'un point mémoire à un seul transistor ont été décrits ici. L'homme de l'art pourra combiner divers éléments de ces divers modes de réalisation et variantes sans faire preuve d'activité inventive.

En particulier, dans le mode de réalisation décrit en détail ci-dessus, le transistor MOS isolé est isolé par une couche isolante 1. On pourrait prévoir que ce transistor MOS soit isolé par jonction, c'est-à-dire soit directement formé au-dessus d'un substrat de silicium de type de conductivité opposé à celui des régions de drain/source, à savoir un substrat de type P si les régions de drain/source, comme la région de corps inférieure, sont de type N.

## Revendications

1. Point mémoire constitué d'un transistor MOS formé sur une couche isolante ayant un drain (8), une source (7) et une région de corps revêtue d'une grille isolée (12), dans lequel la région de corps est divisée dans son épaisseur en deux régions distinctes adjacentes (13, 14) de types de conductivité opposés s'étendant parallèlement au plan de la grille, la région de corps la plus proche de la grille ayant le type de conductivité opposé à celui des drain/source, et dans lequel la région de corps la plus proche de la grille a une épaisseur de 5 à 50 nm, et un niveau de dopage inférieur à 10¹⁶ at./cm³.

2. Point mémoire selon la revendication 1, réalisé à partir d'une structure SOI.

3. Point mémoire selon la revendication 1, reposant sur un substrat semiconducteur ayant le type de conductivité opposé à celui des drain/source.

4. Point mémoire selon la revendication 1, réalisé à partir d'une structure FINFET.

5. Point mémoire selon l'une quelconque des revendications 1 à 3, dans lequel la région de corps la plus éloignée de la grille a une épaisseur de 5 à 50 nm, de préférence de 10 à 40 nm et un niveau de dopage compris entre 10¹⁶ et 10¹⁸ at./cm³.

6. Procédé d'utilisation d'un point mémoire selon l'une quelconque des revendications 1 à 5, dans lequel la tension de source est considérée comme la tension de référence et les régions de source et de drain sont de type N, ce procédé comprenant, dans un ordre quelconque, les étapes suivantes :
écriture d'un 1 : application d'une tension positive sur le drain et, pendant l'application de cette tension positive, application d'une brève tension positive sur la grille,
écriture d'un 0 : application d'une tension très faiblement positive, nulle ou négative sur le drain et application d'une tension positive sur la grille,
lecture : application d'une tension négative sur la grille et d'une tension faiblement positive sur le drain, et
maintien : application d'une tension négative sur la grille et d'une tension faiblement positive ou nulle sur le drain.

## Patentansprüche

1. Speicherpunkt, welcher aus einem MOS-Transistor gebildet ist, der auf einer Isolationsschicht ausgebildet ist, mit einem Drain (8), einer Source (7) und einem Körperbereich, welcher mit einem isoliertem Gate (12) beschichtet ist, wobei der Körperbereich in seiner Dicke geteilt ist in zwei benachbarte unterschiedliche Bereiche (13, 14) von zueinander entgegengesetzten Leitfähigkeitstypen, welche sich parallel zur Ebene des Gates erstecken, wobei der am nächsten zum Gate angeordnete Körperbereich den Leitfähigkeitstyp, welcher demjenigen der Drain/Source entgegengesetzt ist, hat, und wobei der am nächsten zum Gate angeordnete Körperbereich eine Dicke von 5 bis 50 nm und einen Dotierungsgrad kleiner 10¹⁶ At./cm³ aufweist.

2. Speicherpunkt gemäß dem Anspruch 1, welcher auf Grundlage einer SOI-Struktur realisiert ist.

3. Speicherpunkt gemäß dem Anspruch 1, welcher auf einem Halbleitersubstrat, mit dem Leitfähigkeitstyp, welcher demjenigen der Drain/Source entgegengesetzt ist, liegt.

4. Speicherpunkt gemäß dem Anspruch 1, welcher auf Grundlage einer FINFET-Struktur realisiert ist.

5. Speicherpunkt gemäß irgendeinem der Ansprüche 1 bis 3, wobei der am weitesten entfernt vom Gate angeordnete Körperbereich eine Dicke von 5 bis 50 nm, vorzugsweise von 10 bis 40 nm, und einen Dotierungsgrad zwischen 10¹⁶ und 10¹⁸ At./cm³ aufweist.

6. Verfahren zur Nutzung eines Speicherpunkts gemäß irgendeinem der Ansprüche 1 bis 5, wobei die Source-Spannung als die Bezugsspannung betrachtet wird und die Source- und Drain-Bereiche vom N-Typ sind, wobei das Verfahren, in beliebiger Reihenfolge, die folgenden Schritte aufweist:
Schreiben einer 1: Anlegen einer positiven Spannung an Drain und, während des Anlegens dieser positiven Spannung, Anlegen einer kurzen positiven Spannung an das Gate,
Schreiben einer 0: Anlegen einer geringfügig positiven Spannung, Null-Spannung oder negativen Spannung an Drain und Anlegen einer positiven Spannung an das Gate,
Lesen: Anlegen einer negativen Spannung an das Gate und einer geringfügig positiven Spannung an Drain, und
Halten: Anlegen einer negativen Spannung an das Gate und einer geringfügig positiven Spannung oder Null-Spannung an Drain.

## Claims

1. A memory cell formed of an insulated MOS transistor having a drain (8), a source (7), and a bulk region coated with an insulated gate (12), wherein the bulk region is divided across its thickness in two different adjacent regions (13, 14) of opposite conductivity types extending parallel to the gate plane, the bulk region closest to the gate having a conductivity type opposite to that of the drain/source, and wherein the bulk region closest to the gate having a thickness of 5 to 50 nm, and a doping level smaller than 10¹⁶ at./cm³.

2. The memory cell of claim 1, formed from an SOI structure.

3. The memory cell of claim 1, supported by a semiconductor substrate having a conductivity type opposite to that of the drain/source.

4. The memory cell of claim 1, formed from a FINFET structure.

5. The memory cell of any of claims 1 to 3, wherein the bulk region most distant from the gate has a thickness ranging from 5 to 50 nm, preferably from 10 to 40 nm, and a doping level ranging between 10¹⁶ and 10¹⁸ at./cm³.

6. A method for using the memory cell of any of claims 1 to 5, wherein the source voltage is considered as the reference voltage and the source and drain regions are of type N, this method comprising, in any order, the steps of:
writing of a 1: application of a positive voltage to the drain and, during the application of this positive voltage, application of a short positive voltage to the gate,
writing of a 0: application of a very slightly positive, zero, or negative voltage to the drain and application of a positive voltage to the gate,
reading: application of a negative voltage to the gate and of a slightly positive voltage to the drain, and
holding: application of a negative voltage to the gate and of a slightly positive or zero voltage to the drain.
